# EUROPÄISCHE PATENTANMELDUNG

(11) **EP 0 730 231 A2**
(43) Veröffentlichungstag der Anmeldung: **04.09.1996**
(21) Anmeldenummer: 96102690.3
(22) Anmeldetag: 22.02.1996
(51) Int. Cl.: G06F 11/20

(54) **Halbleiterspeicher, dessen Speicherzellen zu einzeln adressierbaren Einheiten zusammengefasst sind und Verfahren zum Betrieb solcher Speicher**

(30) Priorität: 02.03.1995 DE 19507312
(71) Anmelder: SIEMENS AKTIENGESELLSCHAFT, 80333 München (DE)
(72) Erfinder: Meyer, Willibald, Dipl.-Ing., 81737 München (DE)

(57) **Zusammenfassung**

Halbleiterspeicher, dessen Speicherzellen zu einzeln adressierbaren Einheiten 6, wie Speicherblöcken, Bit- oder Wortleitungen, zusammengefaßt sind und der eine mit den Einheiten 6 verbundene Adreßdekodierschaltung 5 aufweist. Zwischen Adreßanschlüssen 1 des Halbleiterspeichers und der Adreßdekodierschaltung 5 ist eine programmierbare Adreßtransformationsanordnung 10 angeordnet, welche Eingänge 2 aufweist, von denen jeder mit einem der Adreßanschlüsse 1 verbunden ist, und welche zu jedem der Eingänge 2 einen entsprechenden Ausgang 3 aufweist, welcher mit der Adreßdekodierschaltung 5 verbunden ist. Die Adreßtransformationsanordnung 10 ist so ausgebildet, daß sie im unprogrammierten Zustand an jeden ihrer Ausgänge 3 ein internes Adreßsignal 7 ausgibt, welches gleich dem am entsprechenden Eingang 2 anliegenden externen Adreßsignal 4 ist. Die Adreßtransformationsanordnung 10 ist in der Weise programmierbar, daß sie an mindestens einem ihrer Ausgänge 3 als internes Adreßsignal 7 ein vom am entsprechenden Eingang 2 anliegenden externen Adreßsignal 4 verschiedenes Signal ausgibt, so daß zumindest teilweise eine Umadressierung der Einheiten 6 erfolgt.

## Beschreibung

Die Erfindung betrifft einen Halbleiterspeicher gemäß dem Oberbegriff des Patentanspruchs 1 sowie ein verfahren zum Betrieb gemäß dem Oberbegriff des Anspruchs 11.

Die Einsetzbarkeit von Halbleiterspeichern für bestimmte Verwendungen wird vor allem dadurch bestimmt, ob die Halbleiterspeicher fehlerhafte Speicherzellen aufweisen oder in welcher Anzahl oder räumlichen Verteilung dies der Fall ist. Bei der Herstellung von Halbleiterspeichern ist es in der Regel nicht erreichbar, daß keine der Speicherzellen fehlerhaft ist. Zwar gibt es auch Anwendungen, beispielsweise im Audio-Bereich, für die ein vollkommen intakter Speicher nicht erforderlich ist, jedoch sind auch in diesen Fällen nur fehlerhafte Speicherzellen in begrenzter Anzahl akzeptabel, weiterhin gibt es Beschränkungen, was die lokale Häufung fehlerhafter Speicherzellen anbetrifft. Vorrangiges Ziel ist aber, Halbleiterspeicher herzustellen, welche auch höchsten Qualitätsansprüchen genügen, wie es beispielsweise für Computerspeicher erforderlich ist.

Um die obengenannten Ziele einer akzeptablen Fehlerhäufigkeit beziehungsweise -dichte oder eines vollkommen fehlerfreien Speichers zu erreichen, ist es bekannt, redundante Wortleitungen und/oder redundante Bitleitungen vorzusehen. Wird in einem im Anschluß an die Herstellung des Halbleiterspeichers durchgeführten Testverfahren das Vorhandensein defekter Speicherzellen detektiert, können diese redundanten Leitungen normale Wort- oder Bitleitungen, die defekte Speicherzellen aufweisen, ersetzen.

Bitleitungen, Wortleitungen und Speicherblöcke sind Einheiten von Speicherzellen, von denen jede durch Spalten-, Reihen- bzw. Blockadressen individuell adressierbar ist.

Da mit der Bereitstellung redundanter Einheiten von Speicherzellen ein schaltungsmäßiger und damit kostenmäßiger Aufwand verbunden ist, ist ihre Anzahl begrenzt. Daher ist es möglich, daß trotz des Einsatzes aller vorhandenen redundanten Einheiten noch fehlerhafte Speicherzellen vorhanden sind, die einen gewünschten Einsatz des Speichers nicht zulassen.

Der Erfindung liegt die Aufgabe zugrunde, einen Halbleiterspeicher und ein Verfahren zu finden, bei welchem eine verbesserte Einsetzbarkeit des Speichers auch beim Vorhandensein von defekten Speicherzellen ermöglicht wird.

Diese Aufgabe wird durch einen Halbleiterspeicher mit den Merkmalen des Anspruchs 1 und ein Verfahren gemäß Anspruch 11 gelöst.

Die einzeln adressierbaren Einheiten, welche mehrere Speicherzellen aufweisen, können beispielsweise Speicherblöcke, Bit- oder Wortleitungen sein.

Durch die Transformation der an den Adreßanschlüssen anliegenden externen Adressen ist es möglich, defekte Einheiten von Speicherzellen adressenmäßig so gegen intakte Einheiten auszutauschen, daß ein möglichst großer, durch externe Adressen zusammenhängend adressierbarer Speicherbereich entsteht. Der Betrieb des Speichers kann dann auf den intakten Speicherbereich beschränkt werden. Diese Lösung bietet den Vorteil, daß entweder zur Erzielung der gleichen Ausbeute wie bei bekannten Halbleiterspeichern weniger redundante Einheiten notwendig sind oder bei gleicher Anzahl an redundanten Einheiten die erreichbare Ausbeute verbessert wird. Speicher, bei denen die erfindungsgemäße Adreßtransformation durchgeführt wird, weisen gegenüber entsprechenden Speichern mit intakten Einheiten eine um die Einheiten mit fehlerhaften Speicherzellen reduzierte Speicherkapazität auf.

Besonders vorteilhaft ist es, wenn die Einheiten mit fehlerhaften Speicherzellen durch die Transformation im Randbereich des logischen Adreßraums angeordnet werden. Dann lassen sich die übrigen Einheiten besonders einfach nutzen, da sie extern als adreßmäßig zusammenhängende Speicherbereiche adressierbar sind. Auf diese Weise läßt sich beispielsweise erreichen, daß der zusammenhängende, fehlerfreie Speicherbereich bei der externen Adresse 0 beginnt. Dies entspricht der gewöhnlichen Adressierung üblicher Anwendungen.

Die Erfindung ermöglicht bei vorgegebener externer Adresse ein Adressieren einer Einheit mit intakten Speicherzellen anstelle eines Adressierens einer Einheit mit fehlerhaften Speicherzellen, welches ohne Adreßtransformation erfolgen würde. Dabei bleiben die internen Adressen der Einheiten unverändert.

Besonders einfach ist die Adreßtransformation folgendermaßen durchzuführen: Es wird speicherintern mindestens eines der externen Adreßsignale durch die Adreßtransformationsanordnung invertiert. Auf diese Weise ist festlegbar, bei welcher externen Adresse eine bestimmte Einheit adressiert wird.

Einen besonders großen nutzbaren Adreßraum des Halbleiterspeichers erhält man, wenn man vor der Durchführung der erfindungsgemäßen Adreßtransformation Einheiten mit fehlerhaften Speicherzellen durch entsprechende redundante Einheiten ersetzt. Die Adreßtransformation wird anschließend nur für die geringere Anzahl der dann immer noch vorhandenen Einheiten mit fehlerhaften Speicherzellen durchgeführt. Durch dieses Vorgehen kann die durch den Einsatz der redundanten Einheiten erzielbare Ausbeute weiter erhöht werden.

Die Adreßtransformationsanordnung kann so gestaltet sein, daß ihre Programmierung reversibel oder irreversibel erfolgen kann. Im Falle reversibler Programmierung ist es möglich, daß bei einem späteren Ausfall weiterer Speicherzellen eine erneute Programmierung der Adreßtransformationsanordnung vorgenommen werden kann, so daß wiederum ein optimierter (nunmehr allerdings kleinerer) Speicherbereich für die Nutzung zur Verfügung steht.

Weitere Ausführungsformen der Erfindung sind in den Unteransprüchen gekennzeichnet.

Die Erfindung wird im folgenden anhand der beiliegenden Zeichnung erläutert. Es zeigen:
Figur 1 eine schematische Darstellung eines erfindungsgemäßen Halbleiterspeichers,
Figuren 2 bis 4 Teile von Ausführungsbeispielen einer erfindungsgemäßen Adreßtransformationsanordnung und
Figur 5 eine schematische Darstellung des erfindungsgemäßen Verfahrens.

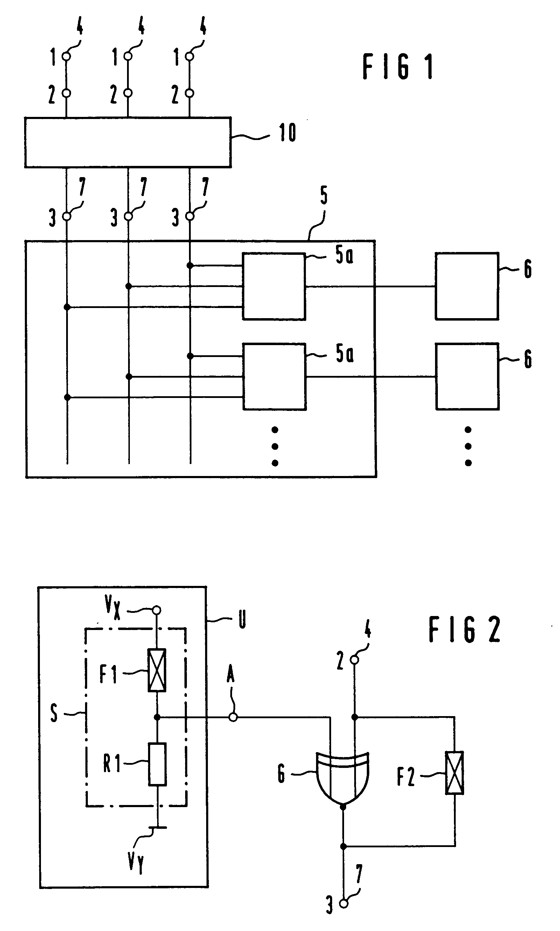

Figur 1 zeigt lediglich die für die Erfindung maßgeblichen Komponenten eines Halbleiterspeichers, welcher individuell adressierbare Einheiten 6 aufweist, die eine Vielzahl von Speicherzellen aufweisen. Die Einheiten 6 können entweder Bitleitungen, Wortleitungen oder Speicherblöcke des Halbleiterspeichers sein. Weitere, üblicherweise vorhandene Komponenten wie Treiber und Puffer sind nicht dargestellt.

Abgebildet ist eine programmierbare Adreßtransformationsanordnung 10 mit Eingängen 2 und Ausgängen 3, wobei jeder Ausgang 3 einem der Eingänge 2 zugeordnet ist. Die Eingänge 2 sind mit je einem Adreßanschluß 1 des Halbleiterspeichers verbunden, an welche externe Adreßsignale 4 anlegbar sind.

Alle externen Adreßsignale 4, welche zum gleichen Zeitpunkt an den Adreßanschlüssen 1 anliegen, bilden eine externe Adresse des Halbleiterspeichers. Die Einheiten 6 sind über eine mit den Ausgängen 3 verbundene Adreßdekodierschaltung 5 adressierbar. Sind die Einheiten 6 Speicherblöcke, handelt es sich bei der Adreßdekodierschaltung 5 um eine Blockdekodierschaltung. Sind die Einheiten 6 Bit- oder Wortleitungen, ist die Adreßdekodierschaltung 5 eine Bitadreß- bzw. Wortadreßdekodierschaltung.

Die Struktur der Adreßdekodierschaltung 5 ist für die Erfindung unerheblich. Sie kann beispielsweise mehrstufig aufgebaut sein oder zentral die Adreßdekodierung vornehmen und die adressierten Einheiten 6 direkt aktivieren. Sie kann auch, wie in der Figur 1 dargestellt, mehrere dezentrale Adreßdekoder 5a aufweisen, von denen jeder einer Einheit 6 zugeordnet und einerseits mit dieser und andererseits mit allen Ausgängen 3 verbunden ist. Eine solche Realisierung liegt beispielsweise vor, wenn die Einheiten 6 Speicherblöcke sind und jedem der Speicherblöcke ein Blockdekoder in Form eines Adreßdekoders 5a zugeordnet ist.

Die Adreßtransformationsanordnung 10 ist so gestaltet, daß sie im unprogrammierten Zustand externe Adreßsignale 4, welche an ihren Eingängen 2 anliegen, als interne Adreßsignale 7 an die entsprechenden Ausgänge 3 weitergibt, so daß die Adreßdekodierschaltung 5 die an den Adreßanschlüssen 1 anliegenden externen Adressen in unveränderter Form auch als interne Adressen erhält. Werden nun im Rahmen eines Speicher-Tests fehlerhafte Speicherzellen in wenigstens einer der Einheiten 6 festgestellt, welche in Anzahl oder Verteilung für einen gewünschten Einsatz des Speichers nicht akzeptabel sind, ist die Transformationsanordnung 10 in der Weise programmierbar, daß an ihren Ausgängen 3 nicht die an den Adreßanschlüssen 1 anliegende externe Adresse als interne Adresse anliegt, sondern eine daraus abgeleitete, vorgebbare andere interne Adresse. Dazu reicht es aus, daß von der Adreßtransformationsanordnung 10 an mindestens einem ihrer Ausgänge 3 ein vom am entsprechenden Eingang 2 anliegenden externen Adreßsignal 4 abweichendes internes Adreßsignal 7 erzeugt wird. So kann die Lage einer Einheit 6 mit fehlerhaften Speicherzellen im logischen Adreßraum des Halbleiterspeichers gezielt verändert werden.

Besonders günstig ist es, wenn sich durch die Programmierung der Adreßtransformationsanordnung 10 für die Einheit 6 mit fehlerhaften Speicherzellen ein Wert seiner zugehörigen externen Adresse ergibt, der im Randbereich des logischen Adreßraums des Halbleiterspeichers liegt. Damit ist ein maximaler zusammenhängend adressierbarer Adreßraum mit für den gewünschten Einsatz des Speichers akzeptablen Einheiten 6 erzielbar.

Die Adreßtransformation der Einheit 6 mit fehlerhaften Speicherzellen wird in vielen Fällen dazu führen, daß auch einige oder alle der intakten Einheiten 6 umadressiert werden. Dies ist jedoch unerheblich.

Weisen mehrere Einheiten 6 fehlerhafte Speicherzellen auf, ist es möglich, durch Einsatz entsprechender Algorithmen diejenige Programmierung der Adreßtransformationsanordnung 10 zu finden, für die bei der gewählten Ausführungsform der Adreßtransformationsanordnung 10 alle Einheiten 6 mit fehlerhaften Speicherzellen weitestmöglich in den Randbereich des Adreßraums verlegt werden. Entsprechend ist die Adreßtransformationsanordnung 10 dann zu programmieren.

Figur 2 zeigt einen Teil eines Ausführungsbeispiels der Adreßtransformationsanordnung 10. Für alle Eingänge 2 und zugehörige Ausgänge 3 der Adreßtransformationsanordnung 10 sind bei diesem Ausführungsbeispiel gleichartige Anordnungen vorgesehen. Dargestellt ist ein XNOR-Gatter G, dessen erster Eingang einer der Eingänge 2 der Adreßtransformationsanordnung 10 ist. Der Ausgang des XNOR-Gatters G ist der zugehörige Ausgang 3 der Adreßtransformationsanordnung 10.

Ein zweiter Eingang des XNOR-Gatters G ist mit dem Ausgang A einer Umkodiereinheit U verbunden. Bei diesem Ausführungsbeispiel weist die Umkodiereinheit U eine Serienschaltung S zwischen einem ersten Potential Vx und einem zweiten Potential Vy des Halbleiterspeichers auf. Dabei kann das erste Potential Vx beispielsweise ein extern an den Halbleiterspeicher angelegtes oder auch ein intern erzeugtes Versorgungspotential sein. Das zweite Potential Vy kann beispielsweise ein Bezugspotential, z. B. Masse sein.

Die Serienschaltung S weist ein mit dem ersten Potential Vx verbundenes programmierbares erstes Element F1 auf, welches über einen Schaltungsknoten, der den Ausgang A der Umkodiereinheit U bildet, sowie einen Widerstand R1, der mit dem ersten Element F1 verbunden ist. Im unprogrammierten Zustand der Adreßtransformationsanordnung 10 verbindet das erste Element F1 das erste Potential VCC mit dem Ausgang A der Umkodiereinheit U, so daß beim XNOR-Gatter G das interne Adreßsignal 7 am Ausgang 3 dem externen Adreßsignal 4 am entsprechenden Eingang 2 entspricht. Beim Programmieren der Adreßtransformationseinheit 10 wird das erste Element F1 programmiert, d. h. die Verbindung zwischen dem Ausgang A der Umkodiereinheit U und dem ersten Potential Vx wird unterbrochen, so daß am Ausgang A im wesentlichen das zweite Potential Vy anliegt. Das interne Adreßsignal 7 am Ausgang 3 des XNOR-Gatters G ist somit invers zum externen Adreßsignal 4 am Eingang 2.

Der Eingang 2 und der Ausgang 3 des Ausführungsbeispiels in Figur 2 sind zusätzlich durch ein optionales, programmierbares zweites Element F2 verbunden, welches das XNOR-Gatter G und damit diesen Teil der Adreßtransformationsanordnung 10 kurzschließt. Das zweite Element F2 ist ebenfalls eine auftrennbare Verbindung. In dem Fall, in dem die Adreßtransformationsanordnung 10 nicht programmiert ist, ist das zweite Element F2 nicht aufgetrennt. In diesem Zustand wird die Wirkung der Gatterlaufzeit des XNOR-Gatters G unterdrückt. Bei diesem Ausführungsbeispiel wird das zweite Element F2 programmiert, das heißt aufgetrennt, wenn das erste Element F1 programmiert wird, wodurch seine Kurzschlußwirkung aufgehoben wird.

Das erste F1 und zweite F2 Element können beispielsweise mittels eines Lasers oder auf elektrische Art zu öffnende Trennstellen sein. Derartige Trennstellen werden allgemein als "Fuses" bezeichnet.

Durch die Transformierung ergeben sich für alle externen Adressen gegenüber dem nichtprogrammierten Zustand geänderte interne Adressen. Somit werden bezüglich der externen Adressen außer der Einheit 6 mit fehlerhaften Speicherzellen auch alle übrigen Einheiten 6 umadressiert. Sofern die übrigen Einheiten 6 intakt sind, ist dies unerheblich. Bei mehreren Einheiten 6 mit fehlerhaften Speicherzellen muß eine optimale Programmierung im Sinne eines größtmöglich herzustellenden intakten Adreßraumes mittels geeigneter Algorithmen ermittelt werden. Die Entwicklung derartiger Algorithmen stellt für den Fachmann aber kein Problem dar.

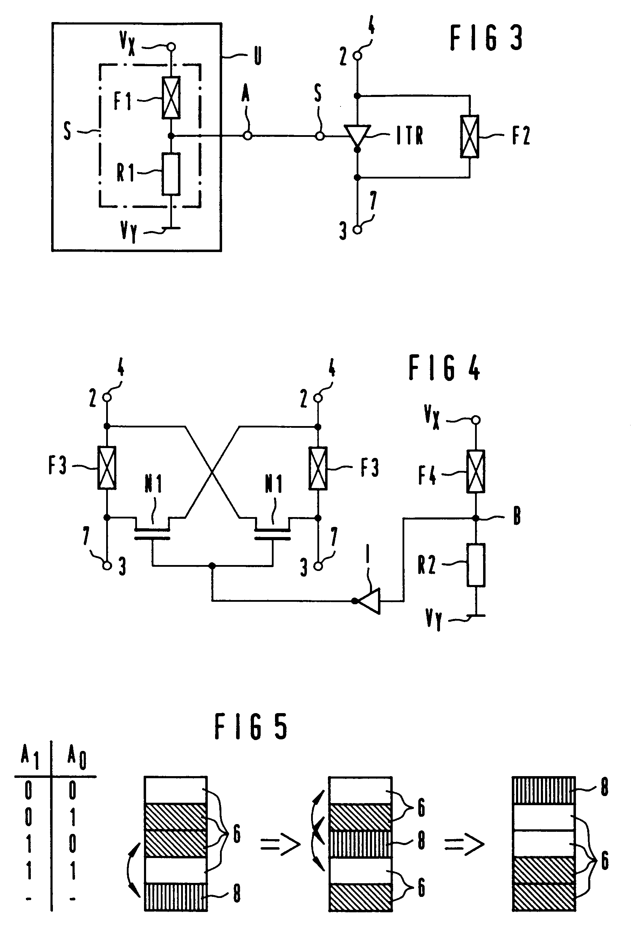

Statt des XNOR-Gatters G in Figur 2 kann auch ein Inverter ITR mit Tristate-Ausgang gemeinsam mit dem zweiten Element F2 gemäß Figur 3 eingesetzt werden, der einen Steuereingang S aufweist, welcher mit dem Ausgang A der Umkodiereinheit U verbunden ist. Ohne Programmierung der Transformationsanordnung 10 liegt am Ausgang A der Umkodiereinheit U das erste Potential Vx an. Dieses versetzt den Tristate-Inverter ITR in einen hochohmigen Zustand. Über das zweite Element F2 sind der Ausgang 3 und der Eingang 2 der Transformationsanordnung 10 verbunden. Soll nun das interne Adreßsignal 7 gegenüber dem externen Adreßsignal 4 invertiert sein, werden das erste F1 und das zweite F2 Element programmiert. Der Tristate-Inverter ITR arbeitet dann wie ein gewöhnlicher Inverter und seine Überbrückung ist aufgehoben.

Figur 4 zeigt ausschnittsweise ein Ausführungsbeispiel der Adreßtransformationsanordnung 10, bei welchem durch die Programmierung die Zuordnung von mindestens zwei ihrer Ausgänge 3 zu den entsprechenden Eingängen 2 vertauscht wird. Dargestellt sind zwei der Eingänge 2 und die zwei zugehörigen Ausgänge 3, mit denen sie über dritte programmierbare Elemente F3 verbunden sind. Außerdem ist jeder der Eingänge 2 mit dem Ausgang 3 des anderen Eingangs 2 über die Kanalstrecke eines n-Kanal-Feldeffekttransistors N1 verbunden. Die Gates der Feldeffekttransistoren N1 sind miteinander und mit einem Ausgang eines Inverters I verbunden. Ein Eingang des Inverters I ist mit einem Schaltungsknoten B zwischen einem vierten programmierbaren Element F4 und einem zweiten Widerstand R2 verbunden, welche eine Serienschaltung zwischen dem ersten Potential Vx und dem zweiten Potential Vy bilden.

Sollen nun die internen Adreßsignale 7 an den Ausgängen 3 vertauscht werden, werden durch Programmierung der Adreßtransformationsanordnung 10 die dritten Elemente F3 und das vierte Element F4 durch Programmierung geöffnet.

Figur 5 zeigt das erfindungsgemäße Verfahren anhand eines Ausführungsbeispiels, bei dem der Halbleiterspeicher vier Einheiten 6 sowie eine redundante Einheit 8 aufweist, welche durch die Kombination zweier externer Adreßsignale 4, in der Zeichnung mit A0 und A1 bezeichnet, adressierbar sind. Dabei zeigt der linke Teil der Figur 5 die externe Adressierung der Einheiten 6 und der redundanten Einheit 8 vor der Durchführung der erfindungsgemäßen Adreßtransformation. Die Einheiten 6 mit den Adressen A₁A₀=01 und A₁A₀=10 weisen fehlerhafte Speicherzellen auf. Die redundante Einheit 8 ist zunächst nicht aktiviert und ihr ist keine externe Adresse zugeordnet.

Der mittlere Teil der Figur 5 zeigt die externe Adressierung der Einheiten 6 und der redundanten Einheit 8, nachdem die Einheit 6 mit fehlerhaften Speicherzellen, welche im linken Teil der Figur 5 die drittniedrigste externe Adresse A₁A₀=10 aufweist, durch die redundante Einheit 8 ersetzt wurde.

Der rechte Teil der Figur 5 zeigt die externe Adressierung der Einheiten 6 und der redundanten Einheit 8, nachdem im Anschluß an die Aktivierung der redundanten Einheit 8 die erfindungsgemäße Adreßtransformation in der Art durchgeführt wurde, daß die Einheit 6 mit fehlerhaften Speicherzellen, welche zuvor die zweitniedrigste Adresse A₁A₀=01 aufwies, adressenmäßig mit der Einheit 6 mit der höchstwertigen Adresse A₁A₀=11 vertauscht worden ist. Bei diesem Ausführungsbeispiel erfolgt die Adreßtransformation durch Invertierung des höchstwertigen Adreßsignals 4, welches in der Figur 5 mit A₁ bezeichnet ist. Eine solche Invertierung kann beispielsweise mittels der in den Figuren 2 und 3 gezeigten Ausführungsbeispiele der Adreßtransformationsanordnung 10 durchgeführt werden.

Die drei Teile der Figur 5 stellen eine Abbildung des logischen Adreßraums des Speichers dar. Nach der Durchführung der Transformation bilden die redundante Einheit 8 mit der neuen externen Adresse 00 sowie die Einheiten 6 mit den neuen externen Adressen 01 und 10 einen zusammenhängenden, extern adressierbaren Speicherbereich ohne fehlerhafte Speicherzellen.

## Patentansprüche

1. Halbleiterspeicher, dessen Speicherzellen zu einzeln adressierbaren Einheiten (6) zusammengefaßt sind und der eine mit den Einheiten (6) verbundene Adreßdekodierschaltung (5) aufweist,
wobei der Halbleiterspeicher Adreßanschlüsse (1) aufweist, an welche externe Adreßsignale (4) zur Adressierung der Einheiten (6) über die Adreßdekodierschaltung (5) anlegbar sind, und wobei die externen Adreßsignale (4) eine externe Adresse bilden,
**dadurch gekennzeichnet,**
daß zwischen den Adreßanschlüssen (1) und der Adreßdekodierschaltung (5) eine programmierbare Adreßtransformationsanordnung (10) angeordnet ist,
daß die Adreßtransformationsanordnung (10) Eingänge (2) aufweist, von denen jeder mit einem der Adreßanschlüsse (1) verbunden ist,
daß die Adreßtransformationsanordnung (10) zu jedem der Eingänge (2) einen entsprechenden Ausgang (3) aufweist, welcher mit der Adreßdekodierschaltung (5) verbunden ist,
daß die Adreßtransformationsanordnung (10) so ausgebildet ist, daß sie im unprogrammierten Zustand an jeden ihrer Ausgänge (3) ein internes Adreßsignal (7) ausgibt, welches gleich dem am entsprechenden Eingang (2) anliegenden externen Adreßsignal (4) ist,
wobei die internen Adreßsignale (7) eine interne Adresse bilden,
und daß die Adreßtransformationsanordnung (10) in der Weise programmierbar ist, daß sie an mindestens einem ihrer Ausgänge (3) als internes Adreßsignal (7) ein vom am entsprechenden Eingang (2) anliegenden externen Adreßsignal (4) verschiedenes Signal ausgibt,
so daß bezüglich der externen Adressen zumindest teilweise eine Umadressierung der Einheiten (6) erfolgt.

2. Halbleiterspeicher gemäß Anspruch 1,
**dadurch gekennzeichnet,**
daß die Adreßtransformationsanordnung (10) in der Weise programmierbar ist, daß sie an mindestens einen ihrer Ausgänge (3) ein internes Adreßsignal (7) ausgibt, welches invers zu dem an ihrem entsprechenden Eingang (2) anliegenden externen Adreßsignal (4) ist.

3. Halbleiterspeicher gemäß Anspruch 1 oder 2,
**dadurch gekennzeichnet,**
daß die Adreßtransformationsanordnung (10) je Adreßanschluß (1) ein XNOR-Gatter (G) und eine Umkodiereinheit (U) aufweist,
daß die Umkodiereinheit (U) einen Ausgang (A) besitzt, an welchem in Abhängigkeit von der Programmierung der Adreßtransformationsanordnung (10) entweder ein erstes Potential (Vx) oder ein zweites Potential (Vy) des Halbleiterspeichers anliegt,
daß ein erster Eingang des XNOR-Gatters (G) einer der Eingänge (2) der Adreßtransformationsanordnung (10) ist, daß ein zweiter Eingang des XNOR-Gatters (G) mit dem Ausgang (A) der Umkodiereinheit (U) verbunden ist
und daß der Ausgang des XNOR-Gatters (G) ein jeweiliger Ausgang (3) der Adreßtransformationsanordnung (10) ist.

4. Halbleiterspeicher gemäß Anspruch 3,
**dadurch gekennzeichnet,**
daß jede Umkodiereinheit (U) eine zwischen dem ersten Potential (Vx) und dem zweiten Potential (Vy) angeordnete Serienschaltung (S) aufweist, daß die Serienschaltung (S) mindestens ein erstes programmierbares Element F1 und einen Widerstand (R1) aufweist, und daß der Ausgang (A) der Umkodiereinheit (U) ein Schaltungsknoten der Serienschaltung (S) zwischen dem ersten Verbindungselement (F1) und dem Widerstand (R1) ist.

5. Halbleiterspeicher gemäß Anspruch 1,
**dadurch gekennzeichnet,**
daß die Adreßtransformationsanordnung (10) in der Weise gescaltet ist, daß die internen Adreßsignale (7) im programmierten Zustand an wenigstens zwei der Ausgänge (3) gegenüber dem unprogrammierten Zustand miteinander vertauscht sind.

6. Halbleiterspeicher gemäß einem der vorstehenden Ansprüche, **dadurch gekennzeichnet,**
daß zwischen den Eingängen (2) und den entsprechenden Ausgängen (3) zweite programmierbare Elemente (F2) angeordnet sind, welche im nicht programmierten Zustand die Adreßtransformationsanordnung (10) überbrücken.

7. Halbleiterspeicher gemäß einem der vorstehenden Ansprüche, **dadurch gekennzeichnet,**
daß die Programmierung der Adreßtransformationsanordnung (10) reversibel ist.

8. Halbleiterspeicher gemäß einem der vorstehenden Ansprüche, **dadurch gekennzeichnet,**
daß die Einheiten (6) Speicherblöcke sind und die Adreßdekodierschaltung (5) eine Blockdekodierschaltung ist.

9. Halbleiterspeicher gemäß einem der Ansprüche 1 bis 7, **dadurch gekennzeichnet,**
daß die Einheiten (6) Bitleitungen sind und die Adreßdekodierschaltung (5) eine Bitadreßdekodierschaltung ist.

10. Halbleiterspeicher gemäß einem der Ansprüche 1 bis 7, **dadurch gekennzeichnet,**
daß die Einheiten (6) Wortleitungen sind und die Adreßdekodierschaltung (5) eine Wortadreßdekodierschaltung ist.

11. Verfahren zum Betrieb von Halbleiterspeichern mit zu adressierbaren Einheiten (6) zusammengefaßten Speicherzellen, wobei wenigstens eine Einheit (6) fehlerhafte Speicherzellen enthält, deren Anzahl oder Anordnung einen Betrieb des Halbleiterspeichers ungünstig beeinflussen,
wobei der Halbleiterspeicher Adreßanschlüsse (1) und eine Adreßdekodierschaltung (5) aufweist
und wobei an die Adreßanschlüsse (1) externe Adreßsignale (4) zur Adressierung der Einheiten (6) über die Adreßdekodierschaltung (5) angelegt werden, die eine externe Adresse bilden,
**dadurch gekennzeichnet,**
daß in einem ersten Schritt innerhalb des Halbleiterspeichers eine Transformation der externen Adressen vorgenommen wird, wobei aus den externen Adreßsignalen (4) transformierte interne Adreßsignale (7) erzeugt werden, die eine interne Adresse bilden,
daß in einem zweiten Schritt die internen Adreßsignale (7) an Stelle der externen Adreßsignale (4) der Adreßdekodierschaltung (5) zugeführt werden
und daß die Transformation in der Weise erfolgt, daß bei Anlegen der externen Adresse mit einem vorgegebenen Adreßwert an die Adreßanschlüsse (1) eine andere Einheit (6) adressiert wird als bei Anlegen der externen Adresse mit dem vorgegebenen Adreßwert ohne Durchführung der Adreßtransformation.

12. Verfahren gemäß Anspruch 11,
**dadurch gekennzeichnet,**
daß die Adreßtransformation in der Weise vorgenommen wird, daß die Einheit (6) mit fehlerhaften Speicherzellen adressenmäßig in einem Randbereich des logischen Adreßraums angeordnet wird, der durch die möglichen Kombinationen der externen Adressen gebildet wird.

13. Verfahren gemäß einem der Ansprüche 11 bis 12,
bei dem der Halbleiterspeicher eine redundante Einheit (8) aufweist, welche zum Ersetzen einer der Einheiten (6) aktivierbar ist,
**dadurch gekennzeichnet,**
daß vor der Durchführung der Adreßtransformation die redundante Einheit (8) aktiviert wird, so daß sie die Einheit (6) mit fehlerhaften Speicherzellen ersetzt, und daß anschließend die externe Adresse einer weiteren Einheit (6) mit fehlerhaften Speicherzellen transformiert wird.

14. Verfahren gemäß Anspruch 13,
**dadurch gekennzeichnet,**
daß die redundante Einheit (8) eine redundante Wortleitung ist.

15. Verfahren gemäß Anspruch 13,
**dadurch gekennzeichnet,**
daß die redundante Einheit (8) eine redundante Bitleitung ist.
